# EUROPÄISCHE PATENTSCHRIFT

(11) **EP 4 179 564 B1**
(45) Veröffentlichungstag und Bekanntmachung des Hinweises auf die Patenterteilung: **07.08.2024**
(21) Anmeldenummer: 20740556.4
(22) Anmeldetag: 08.07.2020
(51) Int. Cl.: H01L 21/683, F16K 11/076, F16K 11/085, F16K 3/26, H01L 21/67, B23Q 3/08, B25B 11/00

(54) **SUBSTRATHALTEVORRICHTUNG, BONDVORRICHTUNG UND VERFAHREN ZUM BONDEN VON SUBSTRATEN**
SUBSTRATE HOLDER DEVICE, BONDING APPARATUS AND BONDING METHOD FOR SUBSTRATES
DISPOSITF DE SUPPORT POUR SUBSTRAT AINSI QUE APPAREIL ET PROCÉDÉ DE LIAISON DE SUBSTRATS

(43) Veröffentlichungstag der Anmeldung: 17.05.2023
(73) Patentinhaber: EV Group E. Thallner GmbH, 4782 St. Florian am Inn (AT)
(72) Erfinder: SÜSS, Jürgen Markus, 4782 St. Florian am Inn (AT); MALLINGER, Jürgen, 4782 St. Florian am Inn (AT)
(74) Vertreter: Schneider, Sascha
(86) Internationale Anmeldenummer: PCT/EP2020/069242
(87) Internationale Veröffentlichungsnummer: WO 2022/008047

(56) Entgegenhaltungen:
- EP-A1- 3 001 451
- CN-A- 109 585 353
- CN-A- 111 383 981
- DE-A1- 102016 101 842
- DE-A1- 102016 106 706
- JP-A- H0 766 093
- US-A1- 2019 368 621
- US-A1- 2019 368 630

## Beschreibung

Die Erfindung betrifft eine Substrathaltervorrichtung, eine Bondvorrichtung sowie ein Verfahren zum Bonden von Substraten.

Die voranschreitende Miniaturisierung in beinahe allen Teilen der Mikroelektronik und Mikrosystemtechnik sorgt für eine ständige Weiterentwicklung aller Technologien, mit deren Hilfe man die Dichte aller Arten von funktionalen Einheiten auf Substraten steigern kann. Zu diesen funktionalen Einheiten gehören beispielsweise Mikrocontroller, Speicherbausteine, MEMS, alle Arten von Sensoren oder Mikrofluidbauteile.

Dokumente zum Stand der Technik sind DE2016106706-A1, CN111383981, JP07-066093-A und US2019/0368630-A1.

In den letzten Jahren wurden die Techniken zur Erhöhung der lateralen Dichte dieser funktionalen Einheiten stark verbessert. In einigen Teilbereichen der Mikroelektronik oder Mikrosystemtechnik sogar so weit, dass eine weitere Steigerung der lateralen Dichte der funktionalen Einheiten praktisch nicht mehr möglich ist. In der Mikrochipherstellung wurde die maximal erreichbare Auflösungsgrenze für lithographisch herzustellenden Strukturen bereits so gut wie erreicht. Physikalische oder technologische Beschränkungen erlauben also in wenigen Jahren gar keine Steigerung der lateralen Dichte funktionaler Einheiten mehr.

Die Industrie begegnet diesem Problem bereits seit einigen Jahren durch die Entwicklung von 2.5D und 3D Technologien. Mit Hilfe dieser Technologien ist es möglich, funktionale Einheiten zueinander auszurichten, übereinander zu stapeln, sie permanent miteinander zu verbinden und durch entsprechende Leiterbahnen miteinander zu vernetzen. Für die Stapeltechnologie ist es unerheblich, wie die funktionalen Einheiten ausgebildet sind. Mit anderen Worten lassen sich mit ähnlicher Technologie gleiche oder verschiedenartige Einheiten miteinander verbinden. Ziel der Technologien ist es, insbesondere die Chipfläche unverändert zu lassen und die Rechenkapazität, die Anzahl der Bausteine zu vervielfachen.

Eine der Schlüsseltechnologien für die Realisierung solcher Strukturen ist das Permanentbonden. Unter dem Permanentbonden versteht man alle Verfahren, mit deren Hilfe Substrate so miteinander verbunden werden können, dass deren Trennung nur durch hohen Energieaufwand und einer damit einhergehenden Zerstörung der Substrate möglich ist. Es existieren unterschiedliche Arten des Permanentbondens.

Eines der wichtigsten Permanentbondverfahren ist das Fusionsbonden, das auch als Direktbonden oder molekulares Bonden bezeichnet wird. Unter Fusionsbonden versteht man den Vorgang des permanenten Verbindens zweier Substrate über die Ausbildung kovalenter Verbindungen. Fusionsbonds entstehen vor allem an den Oberflächen von nichtmetallisch-nichtorganischen Materialien.

Dem Fachmann ist es bekannt, dass bei der Fügung zweier behandelter (insbesondere polierten, geläppten, sich schmiegenden, oxidfreien, identischen) Metalloberflächen mit Vorzug automatisch ein Permanentbond in Form eines Metall-Bonds erfolgt. Bei Substratoberflächen wie beispielsweise Silizium oder Siliziumoxid kann auch zuerst ein sogenannter Prebond erfolgen, der durch einen anschließenden Wärmebehandlungsprozess in einen Permanentbond überführt wird. Die Erzeugung des Prebonds erfolgt vorzugsweise bei Raumtemperatur. In einer ganz besonders bevorzugten Ausführungsform sind die Substratoberflächen so rein, dass die zur Herstellung des permanenten Bonds notwendige Temperatur auf ein Minimum reduziert werden kann. Im idealen Fall erfolgt die Erzeugung des Permanentbonds für alle Arten von Substratoberflächen sofort und ohne einen Prebondschritt, insbesondere ohne einen zusätzlichen Wärmebehandlungsschritt.

Prebondverfahren sind Prozesse, bei denen zwei Substrate alleine durch vander-Waals Kräfte miteinander gebondet werden. Dieser Bondvorgang findet vor allem zwischen Siliziumsubstraten und/oder Siliziumoxidsubstraten statt. Der so hergestellte Bond wird als Prebond bezeichnet, da es sich um eine Vorstufe einer permanenten Verbindung handelt. In der Halbleiterindustrie ist es sehr oft erwünscht, eine durch einen Prebond erzeugte (temporäre) Verbindung wieder zu lösen, wenn man nach dem Prebond feststellt, dass die beiden Substrate nicht optimal oder sogar falsch zueinander ausgerichtet wurden. Die beiden durch einen Prebond miteinander verbundenen Substrate können meistens ohne Beschädigung wieder voneinander getrennt werden. Im Gegensatz zu den anderen in der Offenbarung erwähnten Bondverfahren kommt ein Fusionsbondverfahren, insbesondere als Prebondverfahren gänzlich ohne Bondingadhäsiv aus.

Es ist bekannt, dass mit Fusionsbondverfahren der Prebond für Hybridbonds hergestellt werden kann. Dabei werden wie beim üblichen Fusionsbonden Oxid-Oxid-Bonds hergestellt, welche speziell bei Hybridbonds leitende Kontakte, insbesondere Kupferinseln für die Durchkontaktierung, umrahmen. Die Kupferinseln sind so genannte TSV-s, through silicon vias, welche miteinander durch die Wärmebehandlung des Prebonds kontaktiert werden. Hybridbonden ist eine wichtige Herstellungstechnologie für Speicherchips (Memory), oder Ausleseeinheiten für Bildaufnahmesensoren (backside illuminated image sensors). Mit anderen Worten ist Hybridbonden eine wichtige Technologie für 2,5D oder 3D-Verfahren.

Hybridbonds gelten technologisch als eine Herausforderung, welche erhöhte Ausrichtungsgenauigkeiten und gesteigerte Bedürfnisse der Partikelfreiheit benötigen.

Zum Bonden, insbesondere Fusionsbonden werden die Substrate von Substrathaltern fixiert. Substrathalter verfügen über Fixierungselemente. Die Fixierungen können insbesondere elektronisch ansteuerbar oder regelbar sein, sodass ein Schaltverhalten der Fixierung rechnergestützt, insbesondere automatisiert erfolgen kann.

Die Vakuumfixierung ist die bevorzugte Fixierungsart. Die Vakuumfixierung besteht vorzugsweise aus mehreren Vakuumbahnen, die an der Oberfläche des Substrathalters austreten. Die Vakuumbahnen sind vorzugsweise einzeln ansteuerbar. In einer Anwendung sind einige Vakuumbahnen zu Vakuumbahnsegmenten vereint, die einzeln angesteuert werden können. Die Vakuumbahnen können zum Evakuieren oder Fluten verwendet werden. Jedes Vakuumsegment ist allerdings vorzugsweise unabhängig von den anderen Vakuumsegmenten. Damit erhält man die Möglichkeit des Aufbaus einzeln ansteuerbarer Vakuumsegmente. Die Vakuumsegmente sind vorzugsweise ringförmig konstruiert, denn die meisten Substrate sind kreisrund. Dadurch wird eine gezielte, radialsymmetrische, insbesondere von innen nach außen durchgeführte Fixierung und/oder Loslösung eines Substrats vom Substrathalter ermöglicht. In weiteren bekannten Fixierungen können beliebige Schaltkonzepte durchgeführt werden.

Zur automatisierten Durchführung von Fusionsbonds werden die Substrate zueinander ausgerichtet und zueinander gefügt. Um den Genauigkeitsbedürfnissen der Industrie gerecht werden zu können, müssen dabei die Verzerrungen des gebondeten Substratstapels auf ein Minimum reduziert, im idealen Fall vollständig eliminiert werden.

Ein allgemeines Problem ist die Verkomplizierung der Substrathalter, denn mit jeder zusätzlichen Vakuumbahn benötigt der Substrathalter insbesondere eine Zuleitung, insbesondere eine individuelle Steuerung/Regelung, welche mit elektrischer Verkabelung, Vakuumverkabelung, Befestigungselementen unter anderem den Platzbedarf der Komponenten steigert und die Fehleranfälligkeit des Bonders erhöht. Mit dem Betrieb von elektronischen Komponenten werden zusätzliche Wärmequellen erzeugt, deren Hitzeentwicklung sich auf die Substrate auswirkt. Dementsprechend wird somit beim Bonden eine Vielzahl von nicht quantifizierbaren, zufälligen Fehlerquellen zugeführt, welche den sogenannten Run-out erhöhen.

Neben den Substrathalterungen, die mit Vakuumfixierungen arbeiten, existieren noch alternative Ausführungsformen. Denkbar sind beispielsweise Substrathalterungen mit elektrostatischer Fixierung, magnetischer Fixierung, adhäsiver Fixierung etc.

Substrathalterungen mit elektrostatischer Fixierung wirken über ein elektrostatisches Feld auf das Substrat zurück und können, insbesondere bei Bauteilen, die empfindlich gegen Aufladungen sind, Schäden hervorrufen. Substrathalterungen mit magnetischer Fixierung benötigen magnetisierbare Substrate und können daher selten eingesetzt werden.

Substrathalter mit einer adhäsiven Fixierung haben den gravierenden Nachteil, dass die Fixieroberfläche des Substrathalters sehr weich ist und damit eine flache, ebene Fixierung sehr schwer realisierbar ist.

Es ist daher die Aufgabe der vorliegenden Erfindung eine Substrathaltervorrichtung, eine Bondvorrichtung und ein Verfahren zum Bonden aufzuzeigen, welche die im Stand der Technik aufgeführten Nachteile zumindest zum Teil beseitigen, insbesondere vollständig beseitigen. Weiterhin ist es eine Aufgabe der vorliegenden Erfindung eine verbesserte Substrathaltervorrichtung, eine Bondvorrichtung und ein verbessertes Verfahren zum Bonden aufzuzeigen.

Die vorliegende Aufgabe wird mit den Merkmalen der nebengeordneten Ansprüche gelöst. Vorteilhafte Weiterbildungen der Erfindung sind in den Unteransprüchen angegeben. In den Rahmen der Erfindung fallen auch sämtliche Kombinationen aus zumindest zwei in der Beschreibung, in den Ansprüchen und/oder den Zeichnungen angegebenen Merkmalen. Bei angegebenen Wertebereichen sollen auch innerhalb der genannten Grenzen liegende Werte als Grenzwerte offenbart gelten und in beliebiger Kombination beanspruchbar sein.

Im weiteren Verlauf des Textes ist mit einem Steuerventil, welches vorzugsweise pneumatisch betrieben wird, insbesondere ein Vakuumsteuerventil gemeint.

Demnach betrifft die Erfindung eine Substrathaltervorrichtung zumindest aufweisend:
- mindestens ein Steuerventil und
- mindestens einen Substrathalter mit einer Substrathalteroberfläche und einer Substrathalterrückseite, wobei das Steuerventil zumindest aufweist:
   - ein Ventilgehäuse mit mindestens einem Anschluss,
   - ein antreibbares und in dem Ventilgehäuse gasdicht gehaltenes Steuerelement, und
   - mindestens zwei in dem Ventilgehäuse ausgebildete und fluidisch mit dem Anschluss verbindbare Öffnungen,
   wobei die mindestens zwei Öffnungen durch Antreiben des Steuerelements zumindest teilweise verschließbar sind.

Die Substrathaltervorrichtung ist vorteilhaft dazu ausgebildet mehrere Öffnungen durch zumindest teilweises Verschließen zu regeln. Dafür wird nur ein, insbesondere mechanisches, Steuerventil verwendet, so dass keine einzeln elektronisch steuerbare und nachteilig wärmeabstrahlende Ventile in der Substrathaltervorrichtung verbaut werden müssen. Auf diese Weise kann vorteilhaft die Anzahl der Ventile und insbesondere der Verkabelungen und Verbindungsanschlüsse reduziert werden. Weiterhin kann durch eine reduzierte Wärmeeinbringung der Run-Out-Fehler reduziert, insbesondere verhindert werden, so dass die Qualität bei der Verarbeitung der Substrate erhöht werden kann. Insbesondere kann in Abhängigkeit vom Antreiben, von dem am Anschluss auf das im Steuerventil befindlichen Medium bereitgestellten Druck und durch die Ausgestaltung des Steuerelements vorteilhaft ein gezieltes und kontinuierliches Freigeben beziehungsweise Fixieren eines auf der Substrathalteroberfläche angeordneten Substrates erfolgen.

Weiterhin betrifft die Erfindung eine Bondvorrichtung zum Bonden von mindestens zwei einander zugewandten Substraten, zumindest aufweisend mindestens eine erfindungsgemäße Substrathaltervorrichtung, wobei eine Bondwelle durch eine Antriebgeschwindigkeit des Ventilantriebs und durch ein an dem Anschluss wirkendes Vakuum oder wirkenden Druck beeinflussbar, insbesondere steuerbar, ist.

Die Bondvorrichtung kann durch die Verwendung der Substrathaltervorrichtung effizienter und effektiver betrieben werden. Insbesondere wird durch die verringerte Anzahl an Komponenten die Wärmeeinbringung reduziert, wodurch die Qualität gesteigert und die Fehleranfälligkeit reduziert wird. Besonders vorteilhaft an der Bondvorrichtung ist, dass eine Bondwelle bei einem Bondprozess durch die das Steuerventil aufweisende Substrathaltervorrichtung reguliert werden kann. Dabei kann insbesondere die Form der Bondwelle und deren Ausbreitungsgeschwindigkeit, insbesondere in radialer Richtung, beeinflusst beziehungsweise gesteuert werden.

Weiterhin betrifft die Erfindung ein Verfahren zum Bonden von Substraten, insbesondere mit einer erfindungsgemäßen Bondvorrichtung, wobei eine Ausbreitungsgeschwindigkeit und/oder die Form einer, sich insbesondere radial ausbreitenden, Bondwelle mit einer erfindungsgemäßen Substrathaltervorrichtung beeinflusst wird.

Bei dem Verfahren zum Bonden von Substraten wird vorteilhaft eine Bondvorrichtung verwendet, welche einen Substrathalter aufweist, der eine geringere Wärmeeinbringung aufgrund von einer reduzierten Anzahl von Komponenten, insbesondere elektronisch gesteuerter Ventile, besitzt. Auf diese Weise wird der Bondprozess effektiver und effizienter. Zudem wird die Qualität der Bondverbindung erhöht und eine Fehlerauftrittswahrscheinlichkeit verringert. Bei der Anwendung des Verfahrens ist es möglich, dass eine Bondwelle in Form und Geschwindigkeit vorteilhaft beeinflusst wird. Dabei ist kein individuelles Ansteuern von elektronischen Vakuumventilen notwendig, da mehrere Öffnungen mittels eines, insbesondere rein mechanisch betriebenen Steuerventils, gesteuert werden. Vorteilhaft kann also durch die Antriebsgeschwindigkeit und den durch den Anschluss bereitgestellten Druck ein Bonden von Substraten durchgeführt werden.

In einer bevorzugten Ausführungsform der Substrathaltervorrichtung ist vorgesehen, dass das Steuerelement mindestens einen Steuervorsprung aufweist, wobei die mindestens zwei Öffnungen durch den mindestens einen Steuervorsprung zumindest teilweise verschließbar sind. Der mindestens eine Steuervorsprung verschließt die mindestens zwei Öffnungen beispielsweise zeitlich versetzt oder gleichzeitig. Weiterhin kann durch ein teilweises Verschließen einer Öffnung vorteilhaft eine Regulierung beziehungsweise Drosselung des Steuerventils erfolgen. Der mindestens eine Steuervorsprung ist vorzugsweise mit dem Steuerelement einteilig ausgebildet. Durch die Ausgestaltung und Anordnung des Steuervorsprungs kann vorteilhaft ein gesteuertes Belüften des Vakuumkanals und somit Loslösen eines auf der Substrathalteroberfläche angeordneten Substrates oder ein Fixieren eines auf der Substrathalteroberfläche angeordneten Substrates erfolgen.

In einer bevorzugten Ausführungsform der Substrathaltervorrichtung ist vorgesehen, dass durch Antreiben des Steuerelementes ein individuelles Öffnen, Schließen oder teilweises Verschließen der mindestens zwei Öffnungen in einer bestimmten Sequenz durchführbar ist. Durch kontrolliertes Antreiben kann das Steuerelement vorteilhaft kontrolliert und kontinuierlich bewegt werden, so dass die ein vorteilhaft sequenzielles und insbesondere reguliertes Öffnen, Schließen oder teilweises Verschließen eine jeden Öffnung individuell möglich ist. Auf diese Weise wird ein mechanisches Steuerventil für die Halbleiterindustrie bereitgestellt, welches mehrere Öffnungen, insbesondere mit dem Substrathalter verbundenen Öffnungen, regulieren kann. Eine Beeinflussung des Substrates wird somit vorteilhaft einfach und mit geringer Wärmeeinbringung ermöglicht.

In einer bevorzugten Ausführungsform der Substrathaltervorrichtung ist vorgesehen, dass das Steuerelement als Welle ausgebildet ist und das Antreiben in einer Rotationsbewegung um die Welle erfolgt. Auf diese Weise kann ein Antreiben vorteilhaft als Rotationsbewegung um die Mittelachse der Welle erfolgen und insbesondere Steuervorsprünge abhängig von der Stellung der Welle im Ventilgehäuse die Öffnungen regulieren. Weiterhin kann ein auf der Welle durch die Steuervorsprünge vorgegebenes Regulierungsprogramm vorteilhaft kontinuierlich durch die Drehbewegung erfolgen. Es ist vorteilhaft nicht notwendig das Steuerelement in eine Ausgangsposition zurückzuführen, da nach einer ganzen Drehung erneut das Regulierungsprogram ohne Zeitverzögerung erfolgen kann.

In einer bevorzugten Ausführungsform der Substrathaltervorrichtung ist vorgesehen, dass das Steuerelement als Kolben ausgebildet ist und das Antreiben in einer Axialbewegung entlang des Kolbens erfolgt. Durch eine Axialbewegung des Steuerelementes kann vorteilhaft eine besonders sichere und kontinuierliche Regulierung der Öffnungen erfolgen.

In einer bevorzugten Ausführungsform der Substrathaltervorrichtung ist vorgesehen, dass das Steuerelement austauschbar ist. Auf diese Weise ist eine Änderung einer bestimmten Sequenz beziehungsweise des Regulierungsprogramms möglich. Die Substrathaltervorrichtung kann somit vorteilhaft schnell und flexibel eingestellt werden.

In einer bevorzugten Ausführungsform der Substrathaltervorrichtung ist vorgesehen, dass der mindestens eine Steuervorsprung in Form von einem Gewinde oder in Form von zwei gegenläufigen Gewinden ausgebildet ist. Mittels eines entlang einer Welle oder eines Kolbens ausgebildeten Gewindes oder zweier gegenläufiger Gewinde, kann vorteilhaft das Verschließen der Öffnungen erfolgen. Abhängig von der Ausgestaltung des Anschlusses und des Gehäuses können auf durch die Gewinde unterschiedliche Eingriffsabschnitte und Eingriffsfolgen bestimmt werden.

In einer bevorzugten Ausführungsform der Substrathaltervorrichtung ist vorgesehen, dass das Ventilgehäuse so zu dem Substrathalter, insbesondere an der Substrathalterrückseite, angeordnet ist, dass die mindestens zwei Öffnungen, vorzugsweise drei oder mehr Öffnungen, ausgehend von einem Mittelpunkt der Substrathalteroberfläche in radialer Richtung fluchten. Auf diese Weise kann vorteilhaft eine Beeinflussung der auf einer Substrathalteroberfläche angeordneten Substrate in radialer Richtung nacheinander erfolgen. Weiterhin kann eine sich radial von einem Mittelpunkt ausbreitende Bondwelle des Substrates vorteilhaft in radialer Richtung durch das sequenzielle Verschließen der Öffnungen beeinflusst werden.

In einer bevorzugten Ausführungsform der Substrathaltervorrichtung ist vorgesehen, dass das Ventilgehäuse mindestens drei entlang einer Geraden versetzte Öffnungen aufweist. Die mindestens drei Öffnungen bewirken vorteilhaft, dass die das Freigeben beziehungsweise Fixieren eines Substrates vorteilhaft entlang einer Geraden erfolgt. Vorzugsweise weisen die Öffnungen dabei denselben Querschnitt und dieselbe Querschnittsfläche auf. Weiterhin sind die mindestens drei Öffnungen vorzugsweise regelmäßig und in gleichen Abständen zueinander entlang des Ventilgehäuses angeordnet. Auf diese Weise kann vorteilhaft eine Bondwelle in regelmäßigen Abständen beeinflusst werden.

In einer bevorzugten Ausführungsform der Substrathaltervorrichtung ist vorgesehen, dass das Antreiben durch ein mit dem Steuerelement koppelbaren Ventilantrieb erfolgt, wobei der Ventilantrieb insbesondere außerhalb des Ventilgehäuses angeordnet ist. Eine Anordnung des Ventilantriebes verringert vorteilhaft eine zusätzliche Wärmeeinbringung im Bereich der Substrathaltervorrichtung. Weiterhin ist durch eine Kopplung die beispielsweise Dreh- oder Rotationsbewegung vorteilhaft von dem Steuerelement schnell trennbar oder koppelbar. Zudem können vorteilhaft Getriebe zum Regulieren des Antreibens verwendet werden. Somit ist ein flexibles und schnelles Verschließen der Öffnungen möglich.

In einer bevorzugten Ausführungsform der Substrathaltervorrichtung ist vorgesehen, dass mindestens zwei Verbindungsöffnungen zwischen der Substrathalteroberfläche und der Substrathalterrückseite ausgebildet sind und die mindestens zwei Verbindungsöffnungen gasdicht mit den mindestens zwei Öffnungen des Ventilgehäuses des mindestens einen Steuerventils verbunden sind, so dass ein durch den mindestens einen Anschluss wirkendes Vakuum oder wirkender Druck an den mindestens zwei Verbindungsöffnungen im Bereich der Substrathalteroberfläche bereitstellbar ist. Auf diese Weise kann ein Substrat vorteilhaft auf der Substrathalteroberfläche angeordnet werden. Zudem kann vorteilhaft bei der Montage auf weitere Verbindungsschläuche verzichtet werden. Insbesondere ist durch die geringere räumliche Trennung des Ortes der Beeinflussung und des Steuerventils schnelleres und weniger fehleranfälliges Verschließen der Öffnungen möglich.

In einer bevorzugten Ausführungsform der Substrathaltervorrichtung ist vorgesehen, dass ein auf der Substrathalteroberfläche angeordnetes Substrat in Abhängigkeit von der durch die Steuervorsprünge vorgebbaren bestimmten Sequenz des Steuerventils im Bereich der Verbindungsöffnungen fixierbar, freigebbar und/oder belüftbar ist. Auf diese Weise ist ein besonders flexibles und kontinuierliches Regulieren eine Bondwelle möglich. Weiterhin kann durch ein Belüften, vorzugsweise durch einen bereitgestellten Überdruck, auch ein reduzieren der Ausbreitungsgeschwindigkeit der Bondwelle erfolgen.

In einer bevorzugten Ausführungsform des Verfahrens zum Bonden ist vorgesehen, dass das Beeinflussen in Abhängigkeit von einer Bewegungsgeschwindigkeit des Steuerelementes und von dem wirkenden Vakuum oder dem wirkenden Druck am Anschluss erfolgt. Auf diese Weise kann vorteilhaft durch das Einstellen von der Bewegungsgeschwindigkeit des Steuerelementes und des einstellbaren Drucks am Anschluss des Steuerventils ein Bonden mit eine möglichst geringen Wärmeeinbringung vollzogen werden. Mit anderen Worten kann ein Bonden mit möglichst geringem Run-out vollzogen werden.

Ein wichtiger Aspekt der Erfindung ist das die Vorrichtungen und das Verfahren, mit deren Hilfe der Anschluss, insbesondere die Vakuumanschlüsse eines Substrathalters einzeln und/oder zonenweise, besonders bevorzugt kontinuierlich, gesteuert werden können. Kontinuierlich bedeutet insbesondere in einer bestimmten Sequenz. Der Steueraufwand dadurch vorteilhaft mittels mechanischer Steuerkurven reduziert. Bei dem insbesondere kontinuierlichen Steuern der Vakuumanschlüsse eines Substrathalters wird das auf dem Substrathalter angeordnete Substrat in einer durch das Steuerelement vorgegebenen Sequenz freigegeben oder fixiert, so dass insbesondere eine vom Mittelpunkt des Substrathalters ausgehende Bondwelle beeinflusst beziehungsweise gewünscht gesteuert wird.

Das Vakuumsteuerventil wird bevorzugt über die Welle mittels des Ventilantriebs gesteuert. Es ist jedoch möglich, durch den Betrieb des Ventilantriebs mit einer Rückführungsschleife einen Fusionsbond geregelt durchzuführen, wobei das Vakuumventil an sich als gesteuerte Komponente keine Regelung besitzt. Insofern kann durch den Ventilantrieb, den am Anschluss vorherrschenden Druck und durch die Dimensionierung, insbesondere die Steuervorsprünge die Bondwelle, insbesondere deren Geschwindigkeit und Form, beeinflusst werden.

Es ist dabei auch denkbar, dass eine Bondvorrichtung über einen oder mehrere Sensoren verfügt, so dass eine Bondwelle beim Bonden aufgezeichnet und analysiert werden kann. Durch Berechnung kann die Bondvorrichtung vorzugsweise automatisch eine verbesserte Beeinflussung der Bondwelle beispielsweise durch Regeln der Antriebsgeschwindigkeit des Ventilantriebes, durch Ändern des am Anschluss bereitgestellten Druckes oder durch ein Austauschen des Steuerelementes.

Es ist erwünscht, einen Vakuumsubstrathalter zur Beeinflussung eines Fusionsbonds mit mehreren Steuerventilen, insbesondere Vakuumsteuerventilen, auszustatten. Dies dient insbesondere zur Regelung des Vakuums an einem Vakuumsubstrathalter, welcher einzeln oder in Gruppen schaltbare Vakuumzonen aufweist. Die Schaltung der Vakuumzonen erfolgt mit dem Vakuumsteuerventil oder mit besonders bevorzugt mehreren insbesondere geregelt betriebenen Vakuumsteuerventilen.

In einer besonders vorteilhaften Ausführungsform der Erfindung werden die Vakuumeingänge des Vakuumsteuerventils in einer gemeinsamen Aufspannung mit den Vakuumdurchführungen des Substrathalters gefertigt.

Die Verwendung des Vakuumsubstrathalters mit dem Vakuumsteuerventil wird als ein eigenständiges Verfahren verstanden. Das Verfahren dient zur Beeinflussung insbesondere eines Fusionsbonds zweier Substrate mit zumindest einem Vakuumsteuerventil, um den Run-out des Substratstapels zu minimieren.

Die Erfindung betrifft insbesondere ein Vakuumsteuerventil für die Ansteuerung von mehreren Eingängen, insbesondere an einem Vakuumsubstrathalter für Fusionsbonden, um ein kontrolliertes und reproduzierbares Loslösen des Substrats vom Substrathalter, mit geringem Steuer- beziehungsweise Regelaufwand zu erreichen. Das Vakuumsteuerventil kann mehr als eine Vakuumbahn schalten, sodass die Einzelventilsteuerungen ersetzt werden. Dadurch werden insbesondere die Komplexität und die Fehleranfälligkeit des Bonders reduziert. Die Anzahl der Vakuumleitungen und Vakuumsteuerventilen und Verkabelungen werden reduziert, somit reduziert sich der Steueraufwand, daraus folgend vereinfacht sich die Software der Vorrichtung, welche wiederum die Fehleranfälligkeit des Bonders senkt. Durch die entfallenden Komponenten wird insbesondere die thermische Belastung des Substrathalters mittels parasitären Wärmequellen reduziert, welche Wirkung insbesondere den gesamten Run-out des gebondeten Substratstapels reduziert. Die Minimierung des Run-outs führt zur Qualitätssteigerung.

Das neuartige Vakuumsteuerventil ermöglicht eine hardwarebasierte Steuerung des Bondverlaufs. Dabei ist das Steuerventil vorzugsweise ein rein mechanisches Steuerventil. Das Vakuumsteuerventil ist in der Wirkung wie ein hardwarekodiertes Programm, welches umgestellt werden kann. Die Regelung wirkt sich insbesondere auf die Ausführungsgeschwindigkeit des Programms, welche durch das Steuerventil festgelegt ist, aus. Ein Programmwechsel ist folglich vorteilhaft mit dem Austausch der Welle des Vakuumsteuerventils möglich.

### Steuerventil

Unter dem Steuerventil, insbesondere Vakuumsteuerventil wird insbesondere ein Vakuumsteuerventil zur Beeinflussung des Vakuums mit
- einem Ventilgehäuse, welches den Innenbereich mit Vakuum von der äußeren Atmosphäre gasdicht trennt, und
- mit im Vakuumgehäuse angebrachten Absaugungsanschluss und insbesondere mehreren Eingangsöffnungen versehen ist und
- einen Ventilantrieb zur Erzeugung einer Bewegung, insbesondere Rotation außerhalb des Ventilgehäuses beinhaltet, und
- mit einer Welle versehen ist, welche mit dem Ventilantrieb gekoppelt ist, und welche durch das Ventilgehäuse gasdicht durchgeführt wird, welche die Drehbewegung vom Antrieb in den Innenbereich des Vakuumsteuerventils überträgt und
welche den Fluss des Vakuums zwischen den Eingangsöffnungen und Absaugungsanschlüssen regelt, insbesondere die Eingangsöffnungen öffnet, schließt oder teilweise öffnet, verstanden.

Unter dem Steuerventil, insbesondere Vakuumsteuerventil wird in einer weiteren bevorzugten Ausführungsform insbesondere ein Vakuumsteuerventil zur Beeinflussung des Vakuums mit
- einem Ventilgehäuse, welches den Innenbereich mit Vakuum von der äußeren Atmosphäre gasdicht trennt, und
- mit im Vakuumgehäuse angebrachten Absaugungsanschluss und insbesondere mehreren Eingangsöffnungen versehen ist und
- einen Ventilantrieb zur Erzeugung einer Bewegung, insbesondere Translation außerhalb des Ventilgehäuses beinhaltet, und
- mit einem Linearkolben versehen ist, welche mit dem Ventilantrieb gekoppelt ist, und welche durch das Ventilgehäuse gasdicht durchgeführt wird, welche die Hubbewegung vom Antrieb in den Innenbereich des Vakuumsteuerventils überträgt und
welche den Fluss des Vakuums zwischen den Eingangsöffnungen und Absaugungsanschlüssen regelt, insbesondere die Eingangsöffnungen öffnet, schließt oder teilweise öffnet, verstanden.

### Substrathalter

Ein Substrathalter im Sinne der Erfindung weist zumindest ein oben beschriebenes Steuerventil zur Regelung des Vakuums an dem Substrathalter, insbesondere einem Vakuumsubstrathalter, welcher einzeln oder in Gruppen schaltbare Vakuumzonen aufweist, auf. Das Vakuumsteuerventil ist bevorzugt gasdicht mit dem Vakuumsubstrathalter verbunden. Die Verbindung des Vakuumsteuerventils mit dem Vakuumsubstrathalter erfolgt insbesondere auf der den Substraten abgewandten Seite des Vakuumsubstrathalters (Rückseite) oder an einer Stirnseite des Vakuumsubstrathalters.

In einer besonders vorteilhaften Ausführungsform der Erfindung werden die Vakuumeingänge des Vakuumsteuerventils in einer gemeinsamen Aufspannung mit den Vakuumdurchführungen des Vakuumsubstrathalters gefertigt. Damit lassen sich Fertigungstoleranzen und Fügungstoleranzen eliminieren, mit dem Ausbau von gasdichten Verbindungen zwischen dem Vakuumsubstrathalter und Vakuumsteuerventil können die insbesondere flexiblen Verkabelungen der Vakuumanschlüsse weglassen werden, sodass die Fehleranfälligkeit der Montage reduziert wird.

### Bonder

Ein Vakuumsubstrathalter kann zur Beeinflussung eines Fusionsbonds in einem Bonder, insbesondere Fusionsbonder verwendet werden, welcher mindestens ein Steuerventil beinhaltet.

Als eine insbesondere eigenständige Erfindung wird die Verwendung einer Substrathaltervorrichtung mit dem Steuerventil in einer Bondvorrichtung betrachtet. Das Verfahren dient zur Beeinflussung insbesondere eines Fusionsbonds zweier Substrate mit zumindest einem Vakuumsteuerventil, um den Run-out des Substratstapels zu minimieren.

### Anwendung des Steuerventils in einer Bondvorrichtung

Eine erste Ausführungsform der Bondvorrichtung besteht aus insbesondere einer Fusionsbondvorrichtung mit einem Gestell, Substrathalter, insbesondere Vakuumsubstrathalter für ein erstes Substrat und Substrathalter, insbesondere Vakuumsubstrathalter für ein zweites Substrat, Bewegungsvorrichtungen für jeden Substrathalter, dem Bondpin, Mess- und Regelsysteme für die Ausrichtung der Substrate zueinander, zumindest einem Vakuumsteuerventil für mehrere Vakuumbahnen, die Regelung für das Vakuumsteuerventil, den Antrieb, insbesondere in Form eines elektrischen Antriebes.

Die Vorrichtung beinhaltet vorzugsweise weiterhin einen Übernahmeapparat und Substratdrehapparat, und zumindest einen Roboter für den Transport der Substrate, Druckluft-, Vakuumleitungen und Versorgung, Regelungsrechner, Datenspeicher, Kommunikationsleitungen und Vorrichtungen für die Integration der Vorrichtung in der Herstellungsfabrik.

### Betrieb des Vakuumsteuerventils

Mindestens zwei produktive Betriebszustände (bezogen auf dem Vakuumsteuerventil, bei einem Steuerventil mit Überdruck kehrt sich die Beeinflussung um, so dass das Substrat gezielt belüftet beziehungsweise mit Druck beaufschlagt wird) können in einer Vorrichtung mit dem Vakuumsteuerventil erreicht werden:
In einem ersten Betriebszustand ist die Verbindung zwischen Vakuumeingang und Vakuumausgang des Vakuumsteuerventils offen, sodass am Vakuumausgang beziehungsweise an der Vakuumbahn des Vakuumsubstrathalters ein Unterdruck herrscht.

In einem zweiten produktiven Betriebszustand des Vakuumsteuerventils wird die Verbindung zwischen Vakuumeingang und Vakuumausgang im Vakuumsteuerventil unterbrochen. In diesem Betriebszustand können an der Vakuumbahn des Vakuumsubstrathalters ein Unterdruck oder sonstiger technisch sinnvoller Druckzustand, insbesondere auch Atmosphärenbedingungen, vorliegen.

Es ist denkbar, dass das Vakuumsteuerventil in einem dritten Betriebszustand, eine teilweise geöffnete und/oder teilweise geschlossene Vakuumbahn in einer Zwischenstellung des Vakuumsteuerventils erreicht. Dieser Betriebszustand kann die Wirkung eines Drosselventils an der Vakuumbahn des Vakuumsubstrathalters entfalten.

Weiterhin ist es denkbar, dass das Vakuumsteuerventil mit Überdruck betrieben wird, sodass das Substrat bei geöffneten Kanälen nicht angesaugt sondern abgestoßen wird, insbesondere mit Druck beaufschlagt beziehungsweise belüftet wird.

### Substrathalterung

Eine Substrathalterung wird dazu verwendet, zumindest ein Substrat, insbesondere ein zu bondendes Substrat darauf zu fixieren. Die Substrathalterungen fixieren das zu bondende Substrat auf einer der Substratoberflächen. Die dazu gegenüberliegende Substratseite ist die zu bondende Substratoberfläche, welche beim Bonden das Bondinterface ausbildet.

Substrathalterungen können unterschiedlich ausgebildet sein. Sie können wie folgt ausgeführt werden:
- Mechanische Fixierungen, insbesondere Klemmen,
- Vakuumfixierungen, insbesondere mit einzeln ansteuerbaren/ geregelten Vakuumbahnen oder miteinander verbundenen Vakuumbahnen,
- elektrische Fixierungen, insbesondere elektrostatische Fixierungen,
- elektronisch ansteuerbaren und/oder geregelten Fixierungen, unabhängig vom Fixierungswirkprinzip,
- magnetische Fixierungen,
- Adhäsive Fixierungen, insbesondere sog. Gel-Pak Fixierungen oder als
- Fixierungen mit adhäsiven, insbesondere ansteuerbaren Oberflächen.

Die Vakuumfixierung ist die bevorzugte Fixierungsart. Die Vakuumfixierung besteht vorzugsweise aus mehreren Vakuumbahnen, die an der Oberfläche des Substrathalters austreten. Die Vakuumbahnen sind vorzugsweise einzeln ansteuerbar und/oder regelbar, Dazu wird das Steuerventil, insbesondere als mechanisches Vakuumsteuerventil ausgebildet, verwendet.

Bevorzugt können mehrere Vakuumbahnen gezielt zu Vakuumbahnsegmenten vereint, insbesondere gruppiert werden. Dadurch sind diese einzeln ansteuerbar, evakuierbar und/oder flutbar. Damit erhält man die Möglichkeit mehrere einzeln ansteuerbarer Vakuumsegmente zu verwenden.

Die Vakuumsegmente sind vorzugsweise für kreisrunde Substrate ringförmig konstruiert. Dadurch wird eine gezielte, radialsymmetrische, insbesondere von innen nach außen durchgeführte Fixierung und/oder Loslösung eines Substrats vom Substrathalter ermöglicht. Das Vakuumsteuerventil öffnet zumindest teilweise die entsprechenden Vakuumbahnen und/oder Vakuumsegmente bzw. schließt zumindest teilweise die Vakuumbahnen und/oder Vakuumsegmente, um die Befestigung oder Loslösung der Substrate vom Vakuumsubstrathalter durchzuführen.

### Substrate

Die Substrate können jede beliebige Form besitzen, sind aber bevorzugt kreisrund. Der Durchmesser der Substrate ist insbesondere industriell genormt.

Bevorzugt durch Semi-Standard genormte Substrate insbesondere aus Halbleitermaterial oder Glas oder Glaskeramik oder Kohlenstoff (Diamond like Carbon), welche mono- oder polykristallin sind, werden als Wafer bezeichnet.

Für Wafer sind die industrieüblichen Durchmesser, 1 Zoll, 2 Zoll, 3 Zoll, 4 Zoll, 5 Zoll, 6 Zoll, 8 Zoll, 12 Zoll und 18 Zoll. Grundsätzlich kann jedes Substrat, unabhängig von dessen Durchmesser, eine beliebige Form handhaben. Rechteckige Substrate werden geläufig als Paneele bezeichnet.

Beim Bonden werden zwei Substrate zueinander ausgerichtet und miteinander verbunden. Die Verbindung basiert insbesondere auf van-der-Waals`-Kräfte beim Fusionsbonden (Direktbond, molecular bonding, silicon direct bonding) oder auf kovalente Verbindungen, bevorzugt in Vakuumprozessen.

### Vakuumsteuerventil

Für die Beeinflussung eines Fusionsbonds werden die Substrate vom Substrathalter in einem definierten Ablauf gelöst und miteinander verbunden. Diese Beeinflussung erfolgt einerseits mit dem Bondpin, andererseits mit der Vakuumzonenansteuerung. Die Vakuumzonenansteuerung wird mit dem bevorzugt geregelten Betrieb mindestens eines der Vakuumsteuerventile durchgeführt. Dabei beeinflusst zumindest ein Vakuumsteuerventil das Vakuum des Vakuumsubstrathalters, indem im Ventilgehäuse, und dementsprechend in der Vakuumbahn und auf dem Vakuumsubstrathalter der Druck zielgerichtet geändert wird.

Die Veränderung des Drucks im Ventilgehäuse beziehungsweise am Vakuumsubstrathalter wird insbesondere durch die Welle beeinflusst, welche mit dem Ventilantrieb gekoppelt ist, und welche durch das Ventilgehäuse gasdicht durchgeführt wird, welche die Drehbewegung vom Antrieb in den Innenbereich des Vakuumsteuerventils überträgt und welche den Fluss des Vakuums zwischen den Eingangsöffnungen und Absaugungsanschlüssen regelt, insbesondere die Eingangsöffnungen öffnet, schließt oder teilweise öffnet. Die Versorgungsleitung des Vakuums wird mit im Vakuumgehäuse angebrachten Absaugungsanschluss und insbesondere mehreren Eingangsöffnungen schaltbar verbunden. Der Antrieb, insbesondere ein Ventilantrieb, besonders bevorzugt ein geregelt betriebener bürstenloser Elektromotor wird zur Erzeugung einer Bewegung, insbesondere Rotation außerhalb des Ventilgehäuses verwendet, welche die Welle des Vakuumsteuerventils dreht.

Es ist möglich, dass der Ventilantrieb ein Getriebe, insbesondere ein selbstsperrendes Getriebe und einen geregelt betriebenen bürstenlosen Elektromotor beinhaltet. Damit kann vorteilhaft durch diese konstruktive Anpassung auf Bremsen oder ähnliche Feststellmittel verzichtet werden, so dass keine weiteren Wärmequellen verwendet werden.

Im weiteren Verlauf des Textes werden unterschiedliche Parametersätze offenbart. Einige Parametersätze beziehen sich auf die statischen Merkmale Genauigkeit und Präzision.

Unter Genauigkeit wird ein systematischer Fehler verstanden. Ein systematischer Fehler ist die Abweichung des statisch aus der Stichprobenmenge ermittelten Erwartungswerts eines Parameters vom wahren Wert der Population. Je größer die Genauigkeit, desto kleiner der Wert der Abweichung also desto kleiner der systematische Fehler.

Unter Präzision wird die Streuung einer Messgröße um den Erwartungswert der Stichprobenmenge verstanden. Je größer die Präzision, desto kleiner ist die Streuung.

Dies bedeutet insbesondere für gefügte Substratpaare, dass die Abweichung vom idealen Fügungszustand vermessen wird und die Abweichung in einem Modell quantifiziert, welche zumindest eine Translation in x-Richtung, eine Translation in y-Richtung, (aufgespannte ideale Fügungsebene, also das Bondinterface), eine Rotation der beiden Substrate zueinander um die z-Achse sowie den Restfehler (bezeichnet als run-out) beinhaltet.

Die vorliegende Erfindung minimiert insbesondere den Run-out, indem die Fehlerquelle, welche aus unabhängig geschalteten Ventilen (thermischer Drift durch elektrisch geschalteten Ventilen, Totzeiten und Verzögerungen der Vakuumansteuerungen, etc.) mit einem Vakuumsteuerventil ersetzt. So können Montage, Betrieb und Wartungsaufwand minimiert werden.

Für unterschiedliche Bondprozesse werden bevorzugt die Wellen der Vakuumsteuerungen ausgetauscht, welche unterschiedlichen Steuerkurven besitzen.

Die Welle wird bevorzugt mit einer Kreisfrequenz, kleiner als 1/100 Hz, bevorzugt kleiner 1/10 Hz, besonders bevorzugt kleiner als 1 Hz Kreisfrequenz betrieben.

Der Fachmann kann aus der experimentell ermittelten Durchlaufzeit der Bondwelle den Bondvorgang steuern. Aus der Durchlaufzeit der Bondwelle kann ein Steuerzyklus für den Antrieb des Vakuumventils abgeleitet werden. Mit anderen Worten bedeutet ein Steuerzyklus eine halbe oder eine ganze Umdrehung der Welle oder einen Hub der Translationsbewegung. Somit kann aus der Durchlaufzeit eine Zykluszeit festgelegt werden.

Die Zykluszeit beträgt insbesondere weniger als 15 Sekunden, bevorzugt weniger als 10 Sekunden, besonders bevorzugt weniger als 5 Sekunden, ganz besonders bevorzugt weniger als 3 Sekunden.

Die Winkellage der Welle wird bevorzugt auf kleiner 15 Grad, besonders bevorzugt kleiner als 10 Grad, ganz besonders bevorzugt auf kleiner als 1 Grad, am aller bevorzugtesten kleiner als 0,05 Grad genau in die gewünschte Winkellage geregelt betrieben, sodass die Drehzahl der Welle eine niedrigere Priorität hat als die Genauigkeit der Drehbewegung, welche die Genauigkeit der Drosselung des Vakuums am Vakuumsubstrathalter stellt. Somit kann ein geregelter Betrieb des Vakuumsubstrathalters mit elektronischen Größen, insbesondere rechnergestützt erfolgen.

Für die Beeinflussung des Run-outs des gefügten Substratpaares sind folgende Parameter von Bedeutung:
Die Temperatur (bevorzugt auch die Temperatur des Substrats und des Vakuumsubstrathalters) ist zwischen 0°C und 300°C, bevorzugt zwischen 15°C und 120°C, besonders bevorzugt zwischen Raumtemperatur (insbesondere 20°C) und 75°C.

Die Temperaturschwankung des Substrathalters ist kleiner +/- 5 K, bevorzugt kleiner +/-3 K, besonders bevorzugt kleiner +/- 1 K, ganz besonders bevorzugt kleiner +/- 0,5 K, im optimalen Fall kleiner +/- 0,1K.

Die Vakuumdichtheit, mit anderen Worten die Leckage des Vakuumsteuerventils und des Vakuumsubstrathalters ist kleiner als 10e-5 mbar*l/s, bevorzugt kleiner als 10e-7 mbar*l/s besonders bevorzugt kleiner als 10e-9 mbar*l/s.

Das Vakuumniveau in der Vakuumleitung beträgt insbesondere weniger als 900 mbar, bevorzugt weniger als 850 mbar unter Atmosphärendruck.

In einer besonders bevorzugten Ausführungsform der Vakuumversorgung wird ein geregeltes Vakuum in der Vakuumleitung verwendet. Das Vakuumniveau liegt weniger als 50 mbar, bevorzugt weniger als 25 mbar, besonders bevorzugt weniger als 10 mbar, ganz besonders bevorzugt weniger als 6 mbar, im optimalen Fall weniger als 5 mbar unter Atmosphärendruck. Es ist möglich, dass die zu fügenden Substrate unterschiedliche Temperaturen beim Fügen besitzen, um den gefügten Substratstapel insbesondere die Materialspannung, die Form eines nicht ebenen Substratstapels beeinflussen zu können.

Die Auswahl der Werkstoffe und die Temperaturen gehören zur Prozessentwicklung. Dabei wird insbesondere das Ziel verfolgt, dass das Bondinterface möglichst frei von mechanischen Spannungen gehalten wird.

### Vorrichtung

Die Vorrichtung ist insbesondere eine Bondvorrichtung.

Bevorzugt wird die Bondvorrichtung in einer Modulbauweise nach Kundenwünschen, im Baukastenprinzip erstellt.

Das Bondmodul wird vorzugsweise auf einem Gestell, insbesondere auf einem aktiv schwingungsgedämpften Gestell, aufgestellt. Das Gestell kann aus Naturhartgestein, insbesondere isotropen, feinkörnigen Gesteinssorte wie Granit, insbesondere Gabbro Impala bestehen. In anderen Ausführungsformen des Gestells kann funktional integriertes Reaktionsharzbeton oder funktional integriertes technisches hydraulisch gebundenes Beton verwendet werden.

Die funktionale Integrierung des Gestells kann die Lage und Auslegung von Verankerungspunkten, Zuführungen, gezielte Versteifungen, integrierte Flüssigkeitstemperierung beinhalten. Auf dem Gestell werden die Substrathalter, Ausrichtungs-, Mess-, Bewegungs-, Befestigungs-, sowie teils die Versorgungskomponenten aufgebaut.

Die Vorrichtung beinhaltet neben dem Bondmodul insbesondere auch Transportsysteme, insbesondere zumindest einen Transportroboter, zumindest einen Prealigner, zumindest ein Reinigungsmodul, optional zumindest ein Plasmaaktivierungsmodul, zumindest ein Loadport, zumindest ein Regelungssystem, bevorzugt als Rechner ausgeführt, zumindest ein Bedienungsinterface, sowie Kommunikations-, und Versorgungsleitungen für Medienversorgung wie Druckluft (CDA, clean dry air), Vakuum, Strom, Kühlflüssigkeit, Temperierflüssigkeit.

Wegen der bevorzugten Modulausführung ist es insbesondere vorteilhaft, die Vorrichtung in geschlossener Bauweise staubisoliert und/oder mit sogenannten Filter fan units, also Luftreinigungseinheiten auszustatten, damit die Reinlichkeit und benötigte Staubfreiheit gewährleistet wird. Für das Bonden nicht direkt verwendeten Komponenten der Vorrichtung können in einem lokalen Grauraum oder Grauzone für Reparatur und Montage zugänglich angeordnet werden.

Es ist in einer vorteilhaften Ausführungsform der Bondvorrichtung möglich, dass der Bond in einer von der Reinraumatmosphäre verschiedenen Gasatmosphäre (Inertgas, Funktionsgas für die Kavitäten der Substrate) durchzuführen.

Es ist möglich, dass der Prebond, also das Bondverfahren in Unterdruck, bevorzugt im Vakuum, besonders bevorzugt im Hochvakuum, ganz besonders bevorzugt im Ultrahochvakuum durchgeführt wird.

Insbesondere kann das Vakuumsteuerventil auf der Substrathalterrückseite so angeordnet werden, dass für den Austausch der Welle das staubempfindliche Bondmodul nicht geöffnet werden soll, sondern die Grauzone dazu verwendet wird. Somit kann eine Partikelbelastung des Bonds weiter reduziert werden. Durch die Anordnung des Vakuumsteuerventils in der Grauzone kann als weiterer Vorteil die parasitäre thermische Belastung des Bondmoduls reduziert werden, was wiederum den Run-out minimiert.

Es ist möglich, unterschiedliche Wellen für unterschiedliche Bondsequenzen in der Grauzone an dafür vorgesehenen Ablagen zu lagern.

Die Zeitkonstante der Regelung für die Beeinflussung des Verlaufs der Bondwelle ist bevorzugt 1/10, besonders bevorzugt 1/100, besonders bevorzugt 1/1000 der Zeitkonstante der schnellsten Bewegung der Vorrichtung. Die Regelgeschwindigkeit (Geschwindigkeit der Stellglieder) ist gleich schnell wie die schnellste Bewegung der Vorrichtung.

Die Regler werden insbesondere als Computerprogramme sowie Routinen ausgeführt. Insbesondere vorteilhaft ist die Ausführung der Regler auf Genauigkeit (Vorspannungs-, Positionierungs-, Maßhaltigkeitsgenauigkeit) und Schnelligkeit ausgelegt. Jedoch ist ein Überschwingen beziehungsweise ein Überheben der Regelgröße abweichend vom Sollwert verhindert werden. Die Regelparameter werden aus der Differenz der Sollwert und aus dem IstWert abgeleitet und werden so ausgelegt, dass zu jedem Zeitpunkt der Befestigung des Substrats mittels des Verfahrens zum Bonden und des Bondprozesses ein "Hochschaukeln", insbesondere harmonische Schwingungen oder Transienten, unterbunden werden.

### Verfahren

Als eine insbesondere eigenständige Erfindung wird die Verwendung des Vakuumsteuerventils für einen Fusionsbond verstanden.

Als vorbereitende, optionale Verfahrensschritte werden die Substratvorbereitungen, die Zentrierung der Substrate und das Drehen (Flippen) zumindest eins der Substrate verstanden.

In einem ersten Verfahrensschritt wird das Vakuumsteuerventil in eine Anfangsposition gestellt. Dadurch wird ein Fluidstrom mittels Vakuum von der Oberfläche des Substrathalters in Richtung des Vakuumsteuerventils initiiert.

In einem zweiten Verfahrensschritt wird ein Substrat geladen. Die Ladesequenz beinhaltet den Transport des Substrats zum Vakuumsubstrathalter.

Es werden bei diesem Transport insbesondere die folgenden Aufgaben erledigt:
- das Flippen eines Substrats,
- die Übergabe des Substrats vom Arm des Transportroboters auf mehrere, bevorzugt drei Pins, in besonders bevorzugten Anwendungen Vakuumpins, und das
- Bewegen des Substrats in Richtung des Substrathalters mittels Pins.

In einem dritten Verfahrensschritt wird ein Substrat auf dem Vakuumsubstrathalter befestigt. Dazu wird der Unterdruck mittels der Welle des Vakuumsteuerventils gestellt, insbesondere geregelt gestellt. Der Ventilantrieb, insbesondere ein Motor dreht die Welle des Vakuumsteuerventils. Die Bewegung der Welle beeinflusst die Fluidströmung zwischen den Eingangsöffnungen, also Vakuumkanäle des Vakuumsubstrathalters und des Absaugungsanschluss.

Es ist denkbar, zumindest ein Substrat radialsymmetrisch ab den Mittelpunkt in Richtung des Substratrandes anzusaugen. Sowohl der Vakuumsubstrathalter als auch das Vakuumsteuerventil ist jedoch in der Lage, jegliche Ansaugsequenzen durchlaufen zu können.

In einem vierten Verfahrensschritt (welches optional zeitgleich, bevorzugt zeitverzögert zum dritten Verfahrensschritt ablaufen kann) wird ein zweites Substrat auf einem zweiten Vakuumsubstrathalter analog des zweiten und dritten Verfahrensschrittes befestigt. Dabei ist die Rotation, also das Flippen des Substrats nur bei Bedarf durchzuführen.

In einem fünften Verfahrensschritt werden die zu bondenden Substrate zueinander ausgerichtet.

In einem sechsten Verfahrensschritt wird die Bondsequenz initiiert und durchgeführt, bei welchem die Vakuumsteuerventile insbesondere zueinander synchronisiert und geregelt zumindest ein Substrat kontrolliert loslassen Die Welle eines Vakuumsteuerventils wird in geregelter Weise durch den Vakuumantrieb angetrieben, dass die Fluidströmung zumindest unterbrochen wird. Optional kann die Fluidströmung in der Vakuumbahn sogar vom Unterdruck (Vakuum) auf Überdruck (Abstoßung) umgekehrt werden.

In der Bondsequenz kann ein Bondpin den Kontakt zwischen dem ersten und dem zweiten Substrat in einem Verbindungspunkt im Bondinterface die Bondwelle initiieren.

Der Ablauf der Bondsequenz als ein geregelter Prozessschritt ist bevorzugt, denn damit können die Verzerrungen zumindest reduziert, bevorzugt minimiert, am bevorzugtesten eliminiert werden.

Nach vollständigem Durchlauf der Bondwelle im Bondinterface des Substratstapels ist der Prebond oder Bond fertiggestellt.

In einem siebten Verfahrensschritt wird der Substratstapel vom Vakuumsubstrathalter entladen.

In einem optionalen achten Verfahrensschritt wird der Substratstapel vermessen, um den Ausrichtungs- und Fügeerfolg zu überprüfen. Ist der Run-out unter einem festgelegten Schwellwert, wird der Substratstapel zur Weiterverarbeitung freigegeben.

Wird hingegen ein Run-out-Wert über dem Schwellwert erreicht, wird der Substratstapel insbesondere getrennt und erneut dem Bondverfahren zugefügt oder bei untrennbar verbundenem Substratstapel ausgesondert.

Weitere Vorteile, Merkmale und Einzelheiten der Erfindung ergeben sich aus der nachfolgenden Beschreibung bevorzugter Ausführungsbeispiele sowie anhand der Zeichnungen. Die zeigen in:
Fig. 1 eine schematische Strukturskizze eines Steuerventil des Standes der Technik,
Fig. 2 eine schematische Strukturskizze einer Ausführungsform der erfindungsmäßigen Substrathalterungsvorrichtung mit einem Steuerventil,
Fig. 3 eine Schautafel des Zusammenhangs zwischen Anstellwinkel der Welle und Drucks des Steuerventils und
Fig. 4 eine schematische Strukturskizze eines beispielhaften Steuerelementes.

In den Figuren sind gleiche Bauteile oder Bauteile mit der gleichen Funktion mit den gleichen Bezugszeichen gekennzeichnet.

Die Substrathalterungsvorrichtung 1 beinhaltet einen Substrathalter 2 mit einer Substrathalteroberfläche 2f, auf welcher Oberfläche das zu bearbeitende Substrat aufgelegt und befestigt wird. Weiterhin besitzt der Substrathalter 2 eine, von der Substrathalteroberfläche 2f abgewandte Substrathalterrückseite 2r, welche insbesondere für die Vakuumverbindungen 3 und einzelne Vakuumleitungen 4 zugängig ist. Die Vakuumleitungen 4 sind mit einzelnen Steuer/Regelventilen 5 verbunden, welche mit der nicht dargestellten Vorrichtungssteuerung sowie mit einer nicht dargestellten Vakuumzentralleitung bzw. Vakuumversorgung für die Vorrichtung fluidisch verbunden sind.

Für jede Vakuumverbindung 3 wird im Stand der Technik eine eigene Vakuumleitung 4 sowie ein eigenes Steuer- / Regelventil 5 benötigt. Somit sind Platzbedarf und die Komplexität der Versorgungseinheiten eines üblichen Substrathalters, insbesondere Vakuumsubstrathalters in den letzten Jahren extrem angewachsen.

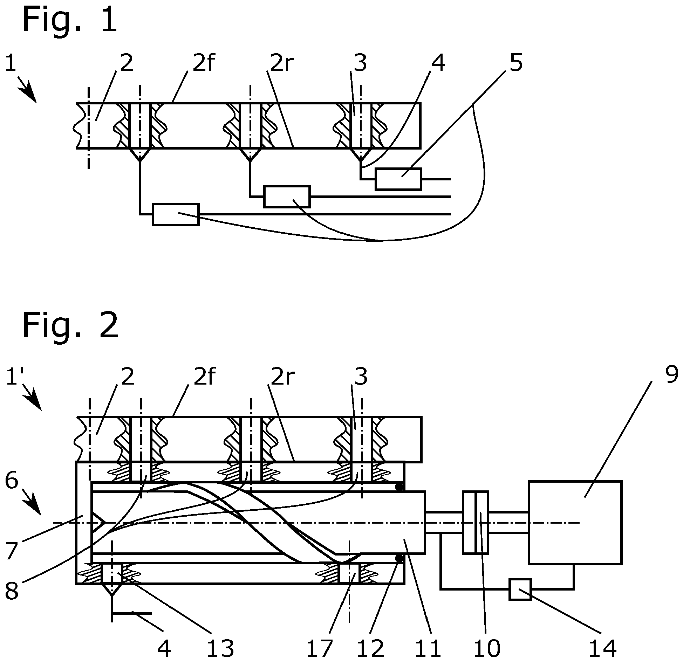

Dagegen bietet das Vakuumsteuerventil 6 in Fig. 2 die Möglichkeit mit nur einem Steuerventil, welches insbesondere rein mechanisch betreibbar ist, mehrere Öffnungen zu regeln.

Fig. 2 stellt eine schematische Strukturskizze einer Ausführungsform einer erfindungsmäßigen Substrathalterungsvorrichtung 1' mit einem Steuerventil 6 dar.

Wie bei Fig. 1 bereits erläutert beinhaltet die Substrathalterungsvorrichtung 1' einen Substrathalter 2 mit einer Substrathalteroberfläche 2f, auf welcher Oberfläche das zu bearbeitende Substrat aufgelegt und befestigt wird. Weiterhin besitzt der Substrathalter 2 eine, von der Substrathalteroberfläche 2f abgewandte Substrathalterrückseite 2r. Auf der Substrathalterrückseite 2r des Substrathalters 2 wird zumindest ein Vakuumsteuerventil 6 gasdicht angebracht.

In einer vorteilhaften Ausführungsform der Substrathalterungsvorrichtung 1' können die Vakuumverbindungen 3 und die dazu korrespondierende Öffnung 8 beziehungsweise Eingangsöffnungen 8 des Ventilgehäuse 7 des Vakuumsteuerventils 6 in einer gemeinsamen Einspannung des Ventilgehäuse 7 mit dem Substrathalter 2 hergestellt werden. So wird die Herstellung kostengünstiger durch die Vermeidung von engen Toleranzen.

Im Ventilgehäuse 7 befindet sich das als Welle 11 ausgebildete Steuerelement 11. Die Welle 11 besitzt mindestens ein umlaufendes Trapezgewinde, welches die Eingangsöffnungen 8 des Ventilgehäuse 7 in Abhängigkeit der Winkelstellung der Welle 11 gasdicht absperren kann. Die Gewindesteigung der Welle kann eine Form und eine Bahn beschreiben, welche der Steuerung des Ansaugens und des Loslassens des Substrates optimal unterstützt, also eine mathematisch stetige Trajektorie einer Funktion sein.

Anstelle eines Trapezgewindes sind beliebige Formen des Steuervorsprungs an der Welle denkbar, solange die äußere theoretische Mantelfläche zylindrisch im Ventilgehäuse die Eingangsöffnungen 8 versperren kann. Mit anderen Worten stellt ein Trapezgewinde eine Art eines Steuervorsprungs dar. Die Breite eines Steuervorsprungs kann berechnet sowie empirischexperimentell angepasst werden. Die Breite des Steuervorsprungs ist theoretisch von größer 0 Grad bis kleiner/gleich 360 Grad möglich. Es sind die Herstellung sowie Toleranzen zu beachten, weswegen in Abhängigkeit des Durchmessers der Welle Öffnungswinkel von 0,01 Grad bis 359.99 Grad möglich sind. In weiteren Ausführungsformen betragen die Öffnungswinkel größer 10 Grad, bevorzugt größer 180 Grad, besonders bevorzugt größer 269 Grad, ganz besonders bevorzugt größer 314 Grad.

Das Vakuum im Ventilgehäuse 7 wird durch ein Vakuumanschluss 13 gewährleistet, welche fluidisch mit einer Vakuumleitung 4 der Vorrichtung, also mit der Versorgungsleitung der Vorrichtung, verbindbar ist.

Insbesondere für das Ablösen des Substrats von der Substrathalteroberfläche 2f wird optional zumindest ein Belüftungsanschluss 17, bevorzugt als Druckdifferenzanschluss ausgeführt.

Somit kann die Steuerung insbesondere zwischen zwei definierten Druckniveaus schalten, insbesondere kann beim Ablösen des Substrats gesteuert zumindest eine Eingangsöffnung 8 rasch ein anderer Druck zugefügt werden.

Mit anderen Worten kann zumindest ein Vakuumanschluss 13 als Druckdifferenzanschluss 17 mit Überdruck oder mit Atmosphärendruck beaufschlagt werden, sodass ein zusätzliches Druckniveau im Vakuumventil bereitgestellt wird, um insbesondere das Substrat vom Substrathalter ablösen zu können. Als weitere Anwendung ist eine gezielte, insbesondere lokale Vorspannung des Substrates mit einer Druckdifferenz möglich.

Das Ventilgehäuse 7 trennt dessen Innenbereich mit Vakuum gasdicht von der äußeren Atmosphäre. Das Ventilgehäuse 7 kann dessen Innenbereich bei der Umkehr des Drucks auf Überdruck gasdicht von der äußeren Atmosphäre ebenfalls trennen.

Die Welle 11 wird von einem Ventilantrieb 9, welcher mit der Welle insbesondere über einer Kopplung 10 mechanisch verbunden ist beziehungsweise verbindbar ist, angetrieben. Der Ventilantrieb 9 erzeugt eine Bewegung, insbesondere eine Rotation außerhalb der Ventilgehäuse 7, welche über die Kopplung 10 die Welle 11 dreht und dadurch die Winkelposition der Welle 11 ändert. Die Welle 11 wird durch das Ventilgehäuse 7 gasdicht durchgeführt. Eine Dichtung 12 sorgt besonders vorteilhaft für die gasdichte Durchführung der Welle 11. Die Welle 11 überträgt die Drehbewegung vom Antrieb 9 in den Innenbereich des Vakuumsteuerventils 6.

Ein Sensor 14 ist für einen geregelten Betrieb des Antriebs 9 beziehungsweise für die Vermessung insbesondere der Winkellage der Welle 11 dargestellt. Durch den geregelten Betrieb des Antriebs 9 kann der Fluss des Vakuums zwischen den Eingangsöffnungen 8 und Absaugungsanschlüssen 13 (nicht alle dargestellt) geregelt werden, insbesondere können die Eingangsöffnungen 8 geöffnet oder geschlossen oder teilweise geöffnet werden.

Die Substrathalterungsvorrichtung 1, 1' beinhaltet andere, nicht dargestellte Versorgungs-, Befestigungs- und Messmittel, welche insbesondere das kontrollierte, ausgerichtete Bonden von Substraten mit einem minimalen Restfehler (Run-out) zu ermöglichen.

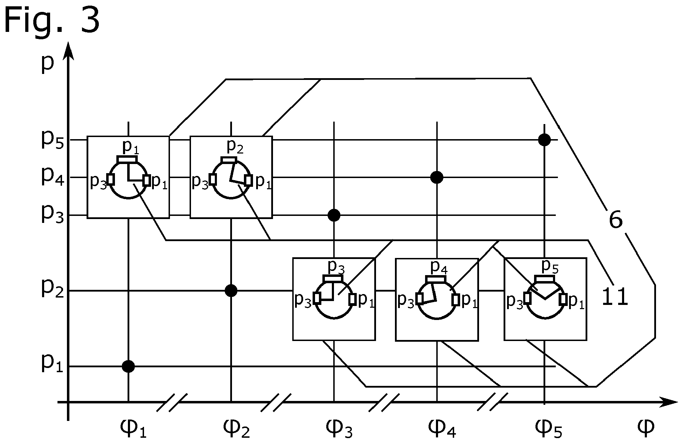

Fig. 3 stellt eine Schautafel des Zusammenhangs zwischen beispielhaften Anstellwinkel der Welle 11 und Druck p des Vakuumsteuerventils insbesondere an den Eingangsöffnungen 8 dar.

Bei einem Anstellwinkel ϕ.1 der Welle 11 ist zumindest ein Vakuumanschluss 13 mit einem Druck p1 direkt mit zumindest einer Eingangsöffnung 8 verbunden, sodass ein Druck p1 an dieser Eingangsöffnung 8 herrscht.

Bei einem Anstellwinkel ϕ.2 der Welle 11 ist zumindest ein Vakuumanschluss 13 mit insbesondere gedrosseltem Druck p2 mit zumindest einer Eingangsöffnung 8 verbunden, sodass ein Druck p2 an dieser Eingangsöffnung 8 herrscht.

Bei einem Anstellwinkel ϕ.3 der Welle 11 ist zumindest ein Vakuumanschluss 13 mit einem Druck p3 mit zumindest einer Eingangsöffnung 8 verbunden, sodass ein Druck p3 an dieser Eingangsöffnung 8 herrscht.

Bei einem Anstellwinkel ϕ.4 der Welle 11 ist zumindest ein Vakuumanschluss 13 mit insbesondere gedrosseltem Druck p4 mit zumindest einer Eingangsöffnung 8 verbunden, sodass ein Druck p4 an dieser Eingangsöffnung 8 herrscht.

Bei einem Anstellwinkel ϕ.5 der Welle 11 ist kein Vakuumanschluss 13 mit einem Druck p1 oder p3 mit zumindest einer Eingangsöffnung 8 verbunden, sodass ein Druck p5 an dieser Eingangsöffnung 8 herrscht. Dieser Zustand kann insbesondere einen Druck im Intervall zwischen p1 bis Atmosphärendruck beinhalten, sodass dieser Schaltzustand der Welle 11 einen ungewissen Druckzustand erzeugt.

Unter der Annahme, dass p4 Atmosphärendruck wäre, gilt die Darstellung der Schautafel für Vakuum.

Sollte das Vakuumsteuerventil 6 in einer weiteren Ausführungsform mit Überdruck am Anschluss 13 betrieben werden, gelten nicht die abgebildeten Druckverhältnisse.

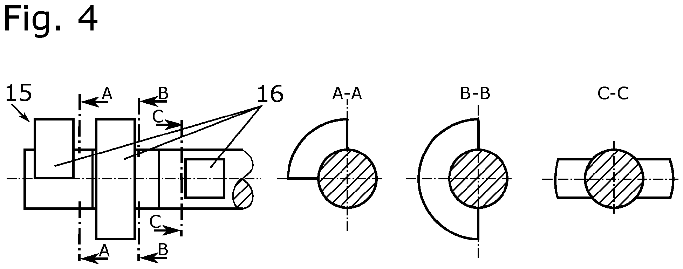

Fig. 4 ist eine schematische Strukturskizze einer Ausführungsform der Welle 11, wobei der Steuervorsprung 15 als eine Segmentwelle 15 ausgebildet ist.

Die Segmentwelle 15 weist Segmente 16 auf. Die Segmente 16 sind auf die Abstände der Eingangsöffnungen 8 des nicht abgebildeten Vakuumsteuerventils abgestimmt.

So können die Segmente 16, wie eine kontinuierliche Welle 11 ebenfalls in Abhängigkeit der Winkellage der Segmentwelle 15 die Eingangsöffnungen öffnen oder teilweise schließen (mit anderen Worten drosseln) oder gasdicht schließen. Die Segmentbauweise der Segmentwelle 15 bringt den konstruktiven Vorteil, dass eine Umrüstung des Vakuumsteuerventils durch den Austausch von Segmenten eine Flexibilität in der Planung der Steuerung eines Fusionsbonds gewährleistet ist. Mit einer endlichen Anzahl unterschiedlicher Segmente lassen sich beliebige Steuerungsaufgaben des nicht dargestellten Vakuumsteuerventils mit hinreichender Genauigkeit durchführen. Insbesondere wird eine Segmentabstufung von jeweils 15 Grad (Sperrsegmente von 15 Grad, 30 Grad, 45 Grad usw.) als konstruktiv vorteilhaft erachtet.

Mit anderen Worten können Segmente 16 mit unterschiedlichen Öffnungswinkeln bzw. Schließwinkeln (s. dazu die Schnitte A-A, B-B, C-C) als exemplarische Darstellungen ausgebildet werden. Damit bleibt mit der Veränderung der Winkellage der Segmente zueinander die Vakuumsteuerung flexibel einstellbar. Die Segmente können, ähnlich einer Nockenwelle, eine Nocke, wie die Schnitte A-A und B-B verdeutlichen, sowie mehr Nocken (zwei wie in C-C) beinhalten.

Dem Fachmann ist es bekannt, wie die Segmente 16 zu fertigen sind und es ist Allgemeinwissen des Konstrukteurs die Montierbarkeit sowie die Einstellbarkeit, Fixierbarkeit und Verdrehsicherung der Segmente 16 der Segmentwelle 15 zueinander als technische Probleme zu lösen.

Insbesondere sind die äußeren Mantelflächen der Segmente, bevorzugt insbesondere die Nocken zumindest poliert und ins Ventilgehäuse mit gasdichter Passung gearbeitet. Die dichtenden Funktionsflächen, also der Sitz der Welle 11, insbesondere der Sitz der Segmente des Ventilgehäuses kann insbesondere gehont sein.

Die Öffnungswinkel eines Segments 16 ist theoretisch von 0,01 Grad (und dazu Komplementär ein Schließwinkel 360- Öffnungswinkel bei einer Nocke am Segment) bis 359,9 Grad möglich. In weiteren Ausführungsformen der Segmente betragen die Öffnungswinkel größer 10 Grad, bevorzugt größer 180 Grad, besonders bevorzugt größer 269 Grad, ganz besonders bevorzugt größer 314 Grad. Der Rechenweg gilt für Segmente 16 mit mehreren Nocken, sowie für Wellen ähnlich einer Schraub- oder Schneckengewinde oder Freiformfläche analog.

In einer besonders bevorzugten, nicht dargestellten, Ausführungsform der Welle 11 oder insbesondere der Segmentwelle 15 können die Segmente 16 oder eine Ausführungsform ähnlich eines doppelgängigem Gewinde mit zwei Anschlüssen 13 des Vakuumsteuerventils 6 zwei unterschiedliche, definierte Drücke dem Ventil zugeführt und entsprechend der Winkellage der Welle dem Eingangsöffnungen 8 zugeführt werden. Ein Vorteil dieser Ausführungsform ist die definierte Abstufung des Drucks im Vakuumsteuerventil 6 mit dem Ziel, die Befestigung sowie das Ablösen des Substrats auf dem Substrathalter 2, insbesondere Vakuumsubstrathalter genauer beeinflussen zu können, um den Run-out zu minimieren. Dabei bleibt die Komplexität der Konstruktion weiterhin auf niedrigem Niveau, sodass die Vorteile des Vakuumsteuerventils mit zusätzlichen Vorteilen gekoppelt werden.

Mit anderen Worten kann die nicht dargestellte, bevorzugte Ausführungsform der Welle 11 oder der Segmentwelle 15 eine durchgehende Medientrennung für definierten Drücke, insbesondere für eine Belüftung ermöglichen.

Ein Vakuumsteuerventil 6 mit zumindest zwei Vakuumzuführungen 13 und einer Welle 11, welche zwei Kammer mit unterschiedlichen Drücken erzeugen kann, kann bei Bedarf wie ein Vakuumsteuerventil 6 mit einer Vakuumzuführung 13 betrieben werden.

Der Schutzbereich des europäischen Patents wird durch die Patentansprüche bestimmt.

### Bezugszeichenliste

- 1, 1': Substrathalterungsvorrichtung
- 2: Substrathalter
- 2f: Substrathalteroberfläche
- 2r: Substrathalterrückseite
- 3: Vakuumverbindung, Verbindungsöffnungen
- 4: Vakuumleitung
- 5: elektronisches Regelventil
- 6: Steuerventil, Vakuumsteuerventil
- 7: Ventilgehäuse
- 8: Eingangsöffnungen, Öffnungen
- 9: Ventilantrieb
- 10: Kopplung
- 11: Steuerelement, Welle
- 12: Dichtung
- 13: Anschluss, Vakuumanschluss
- 14: Sensor
- 15: Segmentwelle
- 16: Steuervorsprung, Segmente
- 17: Belüftungsanschluss, Druckdifferenzanschluss

## Patentansprüche

1. Substrathaltervorrichtung (1') zumindest aufweisend:
- mindestens ein Steuerventil (6) und
- mindestens einen Substrathalter (2) mit einer Substrathalteroberfläche (2f) und einer Substrathalterrückseite (2r),
wobei das Steuerventil (6) zumindest aufweist:
- ein Ventilgehäuse (7) mit mindestens einem Anschluss (13),
- ein antreibbares und in dem Ventilgehäuse (7) gasdicht gehaltenes Steuerelement (11), und
- mindestens zwei in dem Ventilgehäuse (7) ausgebildete und fluidisch mit dem Anschluss (13) verbindbare Öffnungen (8),
wobei die mindestens zwei Öffnungen (8) durch Antreiben des Steuerelements (11) zumindest teilweise verschließbar sind,
wobei das Steuerelement (11) mindestens einen Steuervorsprung (16) aufweist, wobei die mindestens zwei Öffnungen (8) durch den mindestens einen Steuervorsprung (16) zumindest teilweise verschließbar sind,
wobei der mindestens eine Steuervorsprung (16) in Form von einem Gewinde oder in Form von zwei gegenläufigen Gewinden ausgebildet ist.

2. Substrathaltervorrichtung (1') nach Anspruch 1, wobei durch Antreiben des Steuerelementes (11) ein individuelles Öffnen, Schließen oder teilweises Verschließen der mindestens zwei Öffnungen (8) in einer bestimmten Sequenz durchführbar ist.

3. Substrathaltervorrichtung (1') nach wenigstens einem der vorhergehenden Ansprüche, wobei das Steuerelement (11) als Welle (11) ausgebildet ist und das Antreiben in einer Rotationsbewegung um die Welle (11) erfolgt.

4. Substrathaltervorrichtung (1') nach wenigstens einem der vorhergehenden Ansprüche, wobei das Steuerelement (11) als Kolben ausgebildet ist und das Antreiben in einer Axialbewegung entlang des Kolbens erfolgt.

5. Substrathaltervorrichtung (1') nach wenigstens einem der vorhergehenden Ansprüche, wobei das Steuerelement (11) austauschbar ist.

6. Substrathaltervorrichtung (1') nach wenigstens einem der vorhergehenden Ansprüche, wobei das Ventilgehäuse (7) so zu dem Substrathalter (2), insbesondere an der Substrathalterrückseite (2r), angeordnet ist, dass die mindestens zwei Öffnungen (8), vorzugsweise drei oder mehr Öffnungen, ausgehend von einem Mittelpunkt der Substrathalteroberfläche (2f) in radialer Richtung fluchten.

7. Substrathaltervorrichtung (1') nach wenigstens einem der vorhergehenden Ansprüche, wobei das Ventilgehäuse (7) mindestens drei entlang einer Geraden versetzte Öffnungen (8) aufweist.

8. Substrathaltervorrichtung (1') nach wenigstens einem der vorhergehenden Ansprüche, wobei das Antreiben durch ein mit dem Steuerelement koppelbaren Ventilantrieb (9) erfolgt, wobei der Ventilantrieb (9) insbesondere außerhalb des Ventilgehäuses (7) angeordnet ist.

9. Substrathaltervorrichtung (1') nach wenigstens einem der vorhergehenden Ansprüche, wobei mindestens zwei Verbindungsöffnungen (3) zwischen der Substrathalteroberfläche (2f) und der Substrathalterrückseite (2r) ausgebildet sind und die mindestens zwei Verbindungsöffnungen (3) gasdicht mit den mindestens zwei Öffnungen (8) des Ventilgehäuses (7) des mindestens einen Steuerventils (6) verbunden sind, so dass ein durch den mindestens einen Anschluss (13) wirkendes Vakuum oder wirkender Druck an den mindestens zwei Verbindungsöffnungen (3) im Bereich der Substrathalteroberfläche (2f) bereitstellbar ist.

10. Substrathaltervorrichtung (1') nach wenigstens einem der vorhergehenden Ansprüche, wobei ein auf der Substrathalteroberfläche (2f) angeordnetes Substrat in Abhängigkeit von der durch die Steuervorsprünge (16) vorgebbaren bestimmten Sequenz des Steuerventils im Bereich der Vakuumverbindungen fixierbar, freigebbar und/oder belüftbar ist.

11. Bondvorrichtung zum Bonden von mindestens zwei einander zugewandten Substraten, zumindest aufweisend:
- mindestens eine Substrathaltervorrichtung (1, 1') nach wenigstens einem der vorhergehenden Ansprüche,
wobei eine Bondwelle durch eine Antriebgeschwindigkeit des Ventilantriebs (9) und durch ein an dem Anschluss wirkendes Vakuum oder wirkenden Druck beeinflussbar, insbesondere steuerbar, ist.

12. Verfahren zum Bonden von Substraten, insbesondere mit einer Bondvorrichtung nach Anspruch 11, wobei eine Ausbreitungsgeschwindigkeit und/oder die Form einer, sich insbesondere radial ausbreitenden, Bondwelle mit einer Substrathaltervorrichtung nach wenigstens einem der vorhergehenden Ansprüche 1 bis 10 beeinflusst wird.

13. Verfahren nach Anspruch 12, wobei das Beeinflussen in Abhängigkeit von einer Bewegungsgeschwindigkeit des Steuerelementes (11) und von dem wirkenden Vakuum oder dem wirkenden Druck am Anschluss (13) erfolgt.

## Claims

1. A substrate holder device (1') at leastcomprising:
- at least one control valve (6) and
- at least one substrate holder (2) with a substrate holder surface (2f) and a substrate holder rear side (2r),
wherein the control valve (6) comprises at least:
- a valve housing (7) with at least one connection (13),
- a control element (11) which can be driven and which is held gas-tight in the valve housing (11), and
- at least two openings (8) which are formed in the valve housing (7) and which can be connected fluidically to the connection (13),
wherein the at least two openings (8) can be at least partially closed by driving the control element (11),
wherein the control element (11) comprises at least one control projecticn (16), wherein the at least two openings (8) can be at least partially closed by means of the at least one control projection (16),
wherein the at least one control projection (16) is constituted in the form of a thread or in the form of two opposite-running threads.

2. The substrate holder device (1') according to claim 1, wherein an individual opening closing or partial closing of the at least two openings (8) can be carried out in a specific sequence by driving the control element (11).

3. The substrate holder device (1') according to at least one of the preceding claims, wherein the control element (11) is constituted as a shaft (11) and the driving takes place in a direction of rotation about the shaft (11).

4. The substrate holder device (1') according to at least one of the preceding claims, wherein the control element (11) is constituted as a piston and the driving takes place in an axial movement along the piston.

5. The substrate holder device (1') according to at least one of the preceding claims, wherein the control element (11) is exchangeable.

6. The substrate holder device (1') according to at least one of the preceding claims, wherein the valve housing (7) is arranged with respect to the substrate holder (2), in particular with respect to the substrate holder rear side (2r), in such a way that the at least two openings (8), preferably three or mere openings, are aligned in a radial direction proceeding from a centre-point of the substrate holder surface (2f).

7. The substrate holder device (1') according to at least one of the preceding claims, wherein the valve housing (7) comprises at least three openings (8) offset along a straight line.

8. The substrate holder device (1') according to at least one of the preceding claims, wherein the driving takes place by means of a valve drive (9) which can be coupled with the control element, wherein the valve drive (9) is arranged in particular outside the valve housing (7).

9. The substrate holder device (1') according to at least one of the preceding claims, wherein at least two connection openings (3) are constituted between the substrate holder surface (2f) and the substrate holder rear side (2r) and the at least two connection openings (3) are connected gas-tight to the at least two openings (8) of the valve housing (7) of the at least one control valve (6), so that a vacuum or pressure acting through the at least one connection (13) can be provided at the at least two connection openings (3) in the region of the substrate holder surface (2f).

10. The substrate holder device (1') according to at least one of the preceding claims, wherein a substrate arranged on the substrate holder surface (2f) can be fixed, released and/or ventilated in the region of the vacuum connections depending on the specific sequence of the control valve which can be preset by the control projections (16).

11. A bonding device for bonding at least two substrates facing one another, at least comprising:
- at least one substrate holder device (1, 1') according to at least one of the preceding claims,
wherein a bonding wave can be influenced, in particular controlled, by a drive speed of the valve drive (9) and by a vacuum or a pressure acting on the connection

12. A method for bonding substrates, in particular with a bonding device according to claim 11, wherein a propagation rate and/or the form of an, in particular, radially propagating bonding wave is influenced with a substrate holder device according to at least one of preceding claims 1 to 10.

13. The method according to claim 12, wherein the influencing takes place depending on a movement speed of the control element (11) and on the acting vacuum or the acting pressure at the connection (13).

## Revendications

1. Dispositif de support pour substrat (1') présentant au moins :
- au moins une soupape de commande (6) et
- au moins un support pour substrat (2) avec une surface de support pour substrat (2f) et une face arrière de support pour substrat (2r),
dans lequel
la soupape de commande (6) présente au moins :
- un boîtier de soupape (7) comprenant au moins un raccord (13),
- un élément de commande (11) pouvant être entraîné et maintenu étanche aux gaz dans le boîtier de soupape (7), et
- au moins deux ouvertures (8) formées dans le boîtier de soupape (7) et pouvant être reliées fluidiquement avec le raccord (13),
dans lequel les aux moins deux ouvertures (8) peuvent être refermées au moins partiellement par un actionnement de l'élément de commande (11), dans lequel l'élément de commande (11) présente au moins une saillie de commande (16), dans lequel les aux moins deux ouvertures (8) peuvent être refermées au moins partiellement par l'au moins une saillie de commande (16),
dans lequel l'au moins une saillie (16) est conçue sous forme d'un filetage ou sous forme de deux filetages opposés.

2. Dispositif de support pour substrat (1') selon la revendication 1, dans lequel un actionnement de l'élément de commande (11) permet d'effectuer une ouverture, une fermeture ou une fermeture partielle individuelle des aux moins deux ouvertures (8) dans une séquence définie.

3. Dispositif de support pour substrat (1 ') selon au moins l'une des revendications précédentes, dans lequel l'élément de commande (11) est conçue en tant qu'un arbre (11) et l'actionnement est effectué dans un mouvement de rotation autour de l'arbre (11).

4. Dispositif de support pour substrat (1 ') selon au moins l'une des revendications précédentes, dans lequel l'élément de commande (11) est conçu en tant que piston et l'actionnement s'effectue dans un mouvement axial le long du piston.

5. Dispositif de support pour substrat (1 ') selon au moins l'une desrevendications précédentes, dans lequel l'élément de commande (11) peut être changé.

6. Dispositif de support pour substrat (1 ') selon au moins l'une des revendications précédentes, dans lequel le boîtier de soupape (7) est disposé de telle façon par rapport au support pour substrat (2), en particulier à la face arrière de support pour substrat (2r) que les au moins deux ouvertures (8), de préférence trois ouvertures ou plus, sont alignées en direction radiale en partant d'un point médian de la surface de support pour substrat (2f).

7. Dispositif de support pour substrat(1') selon au moins l'une des revendications précédentes, danslequel le boîtier de soupape (7) présente au moins trois ouvertures (8) décalées le long d'une droite.

8. Dispositif de support pour substrat(1') selon au moins l'une des revendications précédentes, dans lequel l'actionnement est effectué par un entraînement de soupape (9) pouvant être couplé à l'élément de commande, dans lequel l'entraînement de soupape (9) est disposé en particulier en-dehors du boîtier de soupape (7).

9. Dispositif de support pour substrat(1') selon au moins l'une des revendications précédentes, dans lequel au moins deux ouvertures de liaison (3) sont formées entre la surface de support pour substrat (2f) et la face arrière de support pour substrat (2r) et les aux moins deux ouvertures de liaison (3) sont reliées en étanchéité aux gaz avec les au moins deux ouvertures (8) du boîtier de soupape (7) de l'au moins une soupape de commande (6), de façon à ce qu'un vide ou une pression agissant à travers l'au moins un raccord (13) puisse être foumi(e) aux au moins deux ouvertures de liaison (3) au niveau de la surface de support pour substrat (2f).

10. Dispositif de support pour substrat(1') selon au moins l'une des revendications précédentes, dans lequel un substrat disposé sur la surface de support pour substrat (2f) peut être fixé, libéré et/ou ventilé en fonction de la séquence définie par les saillies de commande (16) de la soupape de commande au niveau des liaisons avec le vide.

11. Dispositif de liaison pour la liaison d'au moins deux substrats tournés l'un vers l'autre, présentant au moins:
- au moins un dispositif de support pour substrat (1, 1') selon au moins l'une des revendications précédente,
dans lequel une onde de liaison peut être influencée, en particulier commandée, par une vitesse d'actionnement de l'entraînement de soupape (9) et par un vide ou une pression agissant à travers l'au moins un raccord.

12. Dispositif de liaison de substrats, comprenant au moins un dispositif de liaison selon la revendication 11, dans lequel est influencée une vitesse de propagation et/ou la forme d'une onde de liaison se propageant en particulier radialement, avec un dispositif de support pour substrat selon au moins l'une des revendications 1 à 10 précédentes.

13. Procédé selon la revendication 12, dans lequel l'influence s'effectue en fonction d'une vitesse de mouvement de l'élément de commande (11) et du vide ou de la pression agissant sur le raccord (13).
